# EUROPEAN PATENT SPECIFICATION

(11) **EP 1 497 810 B1**
(45) Date of publication and mention of the grant of the patent: **04.07.2007**
(21) Application number: 03746802.2
(22) Date of filing: 16.04.2003
(51) Int. Cl.: G09B 23/18, H05K 1/00

(54) **ELECTROTECHNICAL KIT**
ELEKTROTECHNISCHES KIT
TROUSSE ELECTROTECHNIQUE

(30) Priority: 19.04.2002 CZ 20021366
(43) Date of publication of application: 19.01.2005
(73) Proprietor: SAFAR, Ladislav, 628 00 Brno (CZ)
(72) Inventor: SAFAR, Ladislav, 628 00 Brno (CZ)
(74) Representative: Zak, Vitezslav
(86) International application number: PCT/CZ2003/000024
(87) International publication number: WO 2003/090183

(56) References cited:
- DE-A- 2 211 787
- FR-A- 1 301 953
- GB-A- 1 561 567
- GB-A- 2 205 985
- US-A- 4 933 808
- US-A- 5 540 593

## Description

### Technical Field

The invention relates to an electro-technical kit comprising a primary board, connection means and function modules with electromechanical elements.

### Background of the Invention

For teaching purposes and for acquiring practical experience with design and function of various electronic circuits and equipment there are applied electronic kits, by which all wire connections are replaced by connector means for interconnection of ready-made modules furnished with individual components or groups of components offering pre-set circuitry or even with integrated circuits. There are known various types of such electronic kits. One of them is described in a paper US 2 878 687, featuring a primary board with holes for insertion of guide pins connected to terminals of electric elements. The said pins provide also for attachment of clamping contacts of wire interconnections by means of which a desired circuit is completed. Another system is described in the paper GB 963190, the system comprising a primary with evenly distributed multiple-clamping contacts designed to hold pin terminals of individual electronic elements and interconnecting wiring. By means of the available equipment it is easy to assemble and disassemble a desired circuit. Another embodiment of a kit of the said type is presented in the paper US 3 447 249. The kit consists of blocks assembled similarly to a domino game. Each block carries an electronic component or interconnection means and on at least two contact faces of the block there are located magnets providing for a mechanical couple of two adjacent blocks and their mutual electrical link. There is also known a kit described in US 3 548 261. This kit embodiment features a primary board allowing for attachment of plates carrying electric or electronic elements or just wires. The attachment of plates on the board is carried out by bolts with nuts, the interconnection of the plates is performed by means of individual plate links. A similar embodiment is described in the paper US 5 742 486. A primary board is furnished with a system of regularly distributed pins allowing for attachment of dimensionally unified cases carrying electronic elements and strips serving as interconnecting means. A kit according to the paper US 4 457 721 offers a primary board with multiple holes for insertion of pieces with connectors for terminals of given electronic components. The paper US 4 696 647 describes a kit having a primary board with a regularly distributed system of recesses furnished with contacts. All primary-board contacts are interconnected to form a pre-set network. The recesses allow for insertion of block carrying electronic components. The type of inserted blocks and their position within the board make the final circuitry and resulting equipment, like a calculator, radio, clock, etc. Ready-made blocks comprising logic circuits and connections being mutually interconnected by means of mechanical couplers are described in the paper PCT/GB96/02109. For a potential user all above presented embodiments of a kit of a discussed type offer only limited alternatives. Final circuits which can be created by parts available with a kit are in fact pre-set and for one circuit there exists only one solution.

It is an object of the invention to design an electro-mechanical kit offering a large variety of circuits to be created while maintaining advantages of known embodiments, especially easy assembly and disassembly of completed circuits.

### Summary of the Invention

The foregoing object is achieved by an electro-technical kit with a primary board, connection means and modules with electromechanical elements. The kit in accordance with the present invention has the primary board which is on its both faces divided into an array of first fields and second fields, each of the first fields at one board face being assigned to a second field at the other board face and each field being provided with a system of solid, regularly arranged outside contacts, inside contacts and axis contacts. The outside contacts are connected with outside contacts of adjacent fields, inside contacts of the first fields are by means of horizontal links connected with inside contacts of the same field and with at least some outside contacts of an adjacent field, inside contacts of the second fields are by means of horizontal links connected with inside contacts of the same field and with at least some outside contacts of an adjacent field, Vertically arranged axis central contacts of the first and second fields are by means of horizontal links connected with vertically arranged axis central contacts of adjacent fields, horizontally arranged axis central contacts of the first and second fields are by means of vertical links connected with horizontally arranged axis central contacts of adjacent fields and axis peripheral contacts of both fields are connected with identically located axis peripheral contacts of at least some of the first and second fields. On at least one of the fields of the primary board there is placed a separate connection module provided with a system of bushings for insertion of insertion contacts, the arrangement of bushings corresponding to the arrangement of solid contacts of each field. Each connection module is adapted to hold a functional module having connecting contacts which are arranged at places the positions of which correspond to positions of at least some of the bushings of the connection module. Each field comprise means for attachment of the connection module and the functional module. Further in accordance with the present invention the functional module comprise a housing in which there is placed at least one base carrying at least one electronic element and/or at least one conductor, the terminals of which are led to the bottom face of the base, the housing being provided with a mounting element for attachment of the module to the primary board. Still further in accordance with the invention the outside contacts and/or axis central contacts of each first field on a facial side of the primary board are connected with outside contacts and/or axis central contacts of a respective specularly located second field of the primary board reverse side and outside contacts and/or axis central contacts of each second field on a facial side of the primary board are connected with outside contacts and/or axis central contacts of a respective specularly located second field of the primary board reverse side, such connection being provided for on at least part of the primary board. According to another particular feature of the invention, at least some axis peripheral contacts and at least some supply contacts of at least one first field and one second field are connected with at least some of equally located axis peripheral contacts and/or supply contacts of an adjacent field. According to another preferred feature of the invention the primary board comprise means for connection of at least one supply source and at least one field of the primary board is provided with at least one pair of supply contacts. In a preferred embodiment the insertion contact is provided for by a coil spring.

According to above aspects of the invention there is provided a compact design of a kit without any wire connections, allowing for a large variety of performed links and circuits. The kit makes possible even a very complicated circuits to be constructed, such circuits being designed of a level of electric diagrams or at a level of printed circuit boards and allows also for modelling mathematics operations on sets. Due to its mechanical design the kit offers a protection of a user against unintentional touch or mechanical damage of module electronic components.

### Brief Description of the Drawings

The invention is further illustrated by way of examples presented in the accompanying drawings, in which
Fig. 1 shows a part of the primary board face surface with six first fields and three second fields and with illustrated fixed links between the contacts, the first fields being arranged in two vertical columns and second fields in one vertical column located between the two first-field columns.
Fig. 2 presents an arrangement of contacts of the first field while on the Fig. 3 there is presented an arrangement of contacts of the second field.
Fig. 4 offers a plan view of connection module and on Fig. 5 there is shown the same module in a cross-sectional view taken along lines A'-A' of Fig. 4
Fig. 6 depicts a mechanical design of a functional module in a cross-sectional view, incl. its location on a connection module and positions of insertion contacts.
Fig. 7 presents an example of interconnections of a functional module with only wire links and
Fig. 8 illustrates interconnections of a functional module with four transistors.
Fig. 9 shows an electric diagram of a simple circuit and on
Fig. 10 there is shown a top view on a primary board the fields of which are fully occupied with connection modules. In the right upper part of the board seven fields being arranged in two adjacent columns carry functional modules which create the electric circuit according to Fig. 9. Within the left lower part of the board there is shown internal contacts interconnections of the board.
Fig. 11 illustrates some examples of possible configurations of a single module.

### Description of Preferred Embodiments

The electro-technical kit according to the invention comprise a primary board 1, connection modules 2 and functional modules 3.

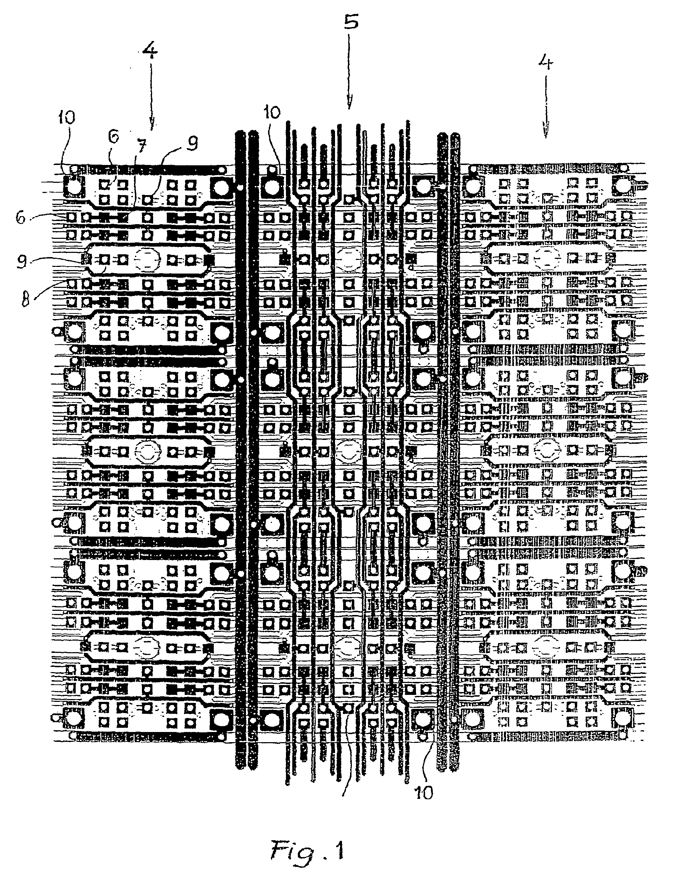

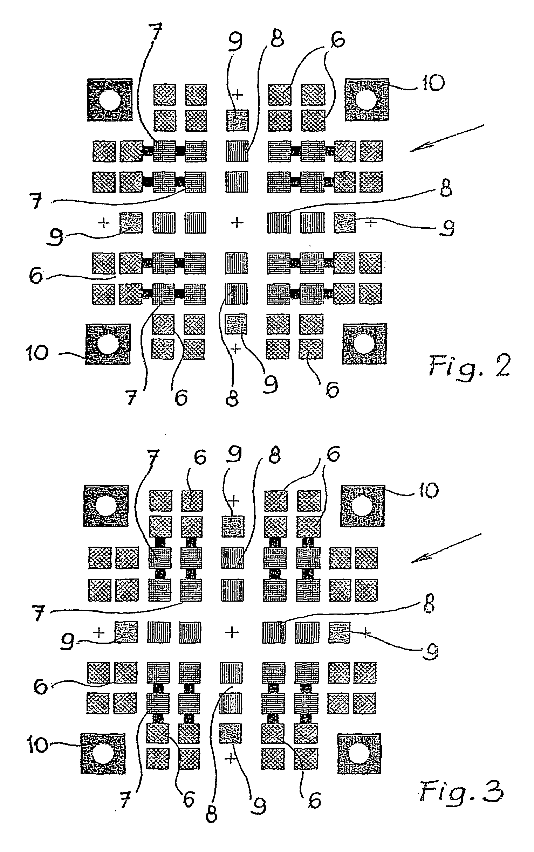

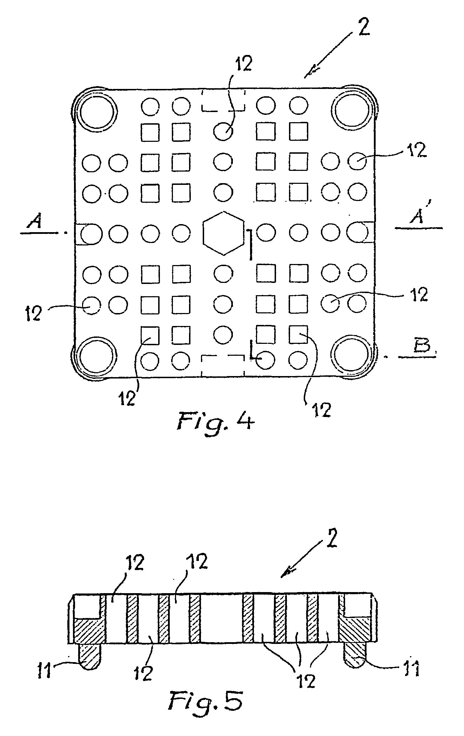

Referring to Fig. 1, there is shown the primary board 1 which is on both sides, i.e. on both surfaces, divided into squared, regularly distributed first fields 4 and second fields 5, each of the fields 4,5 being equipped with a system of contact points. To each of the first fields 4 on one side of the primary board 1 there is specularly allocated the second field 5 on the board opposite side. The difference between the first field 4 and the second field 5 is in internal interconnection of the field contact points, the arrangement of which is the same on both the fields 4,5. By the embodiment presented on Fig. 1 the fields having the same contact interconnection are arranged in columns in such a way, that columns comprising the first fields 4 and columns of the second fields 5 regularly alternate. The first fields 4 and the second fields 5 may be mutually arranged also in other way, e.g. checkerboard pattern. It is possible to work on each of the primary board 1 side independently with respect to the other side. The contact points of the first and second fields 4,5 are arranged in a regularly distributed system of outside contacts 6, inside contacts 7 and axis contacts 8,9. All the contacts 6,7,8,9 are firm, fixed ones. An example of arrangement of the contacts 6,7,8,9 of the first field 4 and of the second field 5 is presented on Fig. 2 and Fig. 3 respectively. Both the first field 4 and the second field 5 are by axis contacts 8,9, i.e. by contacts located in axes of each field, divided into four sections. Each section comprise a supply contact 10 located in a corner identical to a respective field outer corner. The supply corner 10 has a hole opening to the primary board 1 other side. Along the two outer sides of each field section there are two rows of two outside contacts 6. In the remaining part of the section, towards the axis contacts 8,9, there are located four inside contacts 7. Within the axes of the first and second fields 4,5 there are situated six contacts. Symmetrically to the field centre there are four centre contacts 8 and two peripheral contacts 9. The number of contact points in each field 4,5 may be of course different to the figures presented in the above described example, without changing the idea of the invention. Outside contacts 6 of each first field 4 and second field 5 are connected with outside contacts 6 of adjacent fields 4,5. Ail outside contacts 6 of each first field 4 on the facial side of the primary board 1 are further connected with outside contacts 6 of a respective specularly arranged second field 5, located on the reverse side of the primary board 1. Similarly it applies that all outside contacts 6 of each second field 5 on the facial side of the primary board 1 are further connected with outside contacts 6 of a respective specularly arranged first field 4, located on the reverse side of the primary board 1. The naming of the sides of the primary board 1 as facial and reverse ones serves only for mutual differentiation of both sides but has no effect upon their construction or function.

Inside contacts 7 of each of the first fields 4 are by means of horizontal links mutually interconnected with other inside contacts 7 of the same field and further with adjacent outside contacts 6 of the same first field 4 and with at least some outside contacts 6 of the adjacent field, as illustrated in the Fig. 2.

Inside contacts 7 of each of the second fields 5 are by means of vertical links mutually interconnected with other inside contacts 7 of the same field and further with adjacent outside contacts 6 of the same first field 4 and with at least some outside contacts 6 of the adjacent field, as illustrated in the Fig. 3. Vertically arranged axis central contacts 8 of each of the first fields 4 are by means of horizontal links connected with vertically arranged central axis contacts 8 of other first fields 4. Horizontally arranged axis central contacts 8 of each of the second fields 5 are by means of vertical links connected with horizontally arranged axis central contacts 8 of adjacent second fields 5.

Axis peripheral contacts 9 and supply contacts 10 of each of the first fields 4 and the second fields 5 are connected with similarly located axis peripheral contacts 9 and supply contacts 10 of respective adjacent field 4,5. The supply contacts 10 may be connected also in a different way, either in a separate network or only a part of them being mutually interconnected or they may even be not interconnected at all.

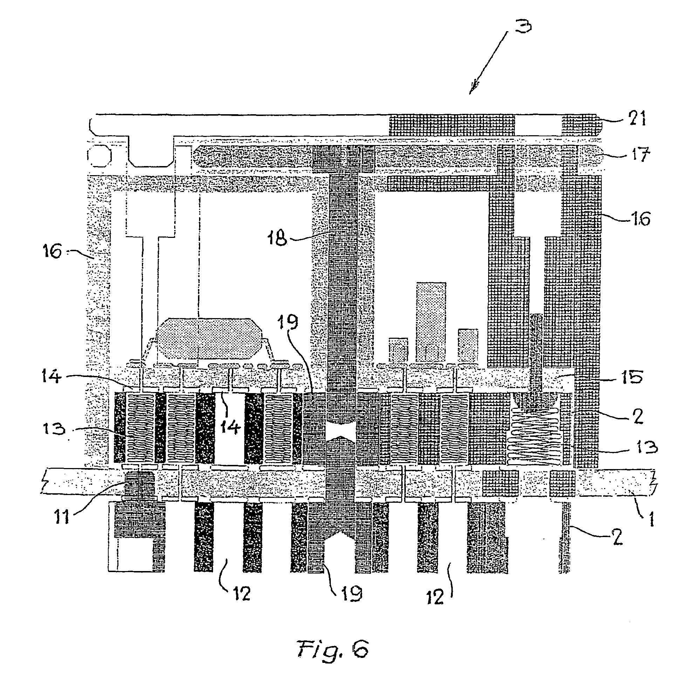

On each field 4,5 of both sides of the primary board 1 there is located a separate connection module 2 serving as a seat for a functional module 3. For proper location of connection modules 2 on the primary board 1 there are used two protrusions 11 on the module bottom surface, the protrusions 11 fitting in corresponding holes in the primary board 1. The said connection modules 2 are further furnished with a system of bushings 12 for placement of insertion contacts 13. Positions of the bushings 12 correspond to positions of fixed contacts of each of the first and second fields 4,5. Insertion contacts 13 serving for desired interconnection of applied functional modules 3 are provided for by coil springs, but also other means, like conducting rubber, may be used. The functional modules 3 serve as units carrying electronic circuits, like integrated circuits or electric components, i.e. resistors, capacitors or just wires or as the case may be, any combination of above elements. Terminals of the said elements are run out at places, the positions which correspond to positions of at least some of the bushings 12 of the primary board 1. An example of a design of a functional module 3 together with its seat on the connection module 2 is shown on Fig 6. Fig. 6 presents a cross-sectional view upon both modules 2,3, the cross-section being performed along a plane A-B according to Fig. 4. The functional module 3 is provided with at least one board carrying at least one electronic and/or at least one conductor or wire. In the illustrated embodiment the board is represented by a base 15 having connecting contacts 14 at its bottom surface. The connecting contacts 14 coincides with terminals of individual elements of the module. The functional module 3 may also comprise a an auxiliary board with further array of elements. All the elements together the base 15 are covered by a housing 16. The housing 16 bottom rim overlapping the base 15 constitutes a sleeve which allows for a seat of the functional module 3 upon the connection module 2. On the upper side the housing 16 is closed by cover 17 comprising coupling means for fixing the module to the primary board 1. In a preferred embodiment the coupling means are provided for by a bolt 18 engaging with a nut 19 attached in a centre of the connection module 2. For the purpose also other means for disassembleable connections may be applied. The inside arrangement of each functional module 3 may be illustrated on a top 21 of the cover 17. Such an illustration shall facilitate the work with the functional modules 3. The capacity of contact points of the functional modules 3 need not to be always fully applied within an assembled circuit. The nut 19, besides its mechanical function as described above may also serve as electric conducting link between facial and the reverse sides of the primary board 1. By disassembly of a circuitry the functional modules 3 may serve as a switch as there is primarily interrupted the connection between the supplies contacts 10 and only subsequently the connection on connecting contacts 14.

The functional module 3 may have even larger size than defined by a single field 4,5 of the primary board 1 and may thus be attached to the primary board 1 of means of more than just one connection modules 2.

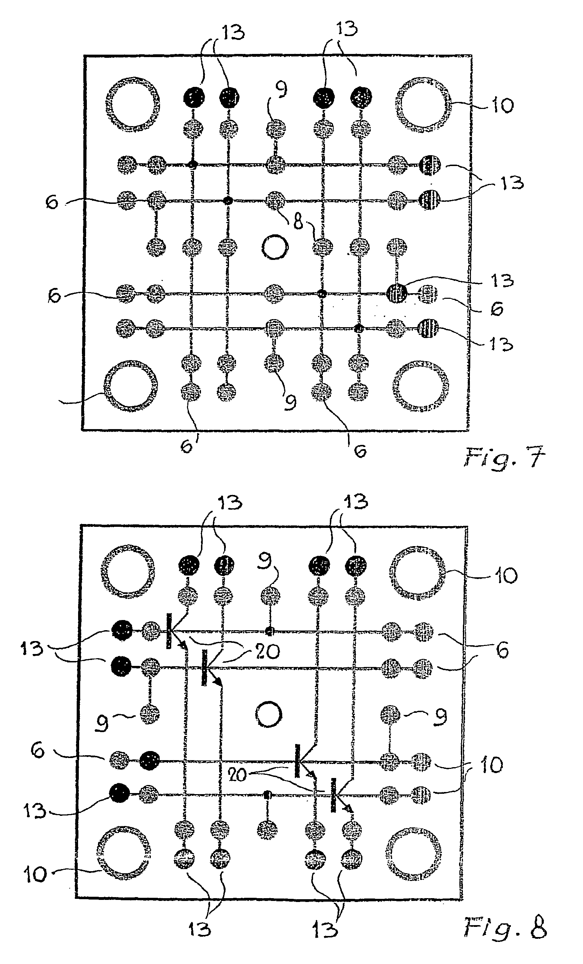

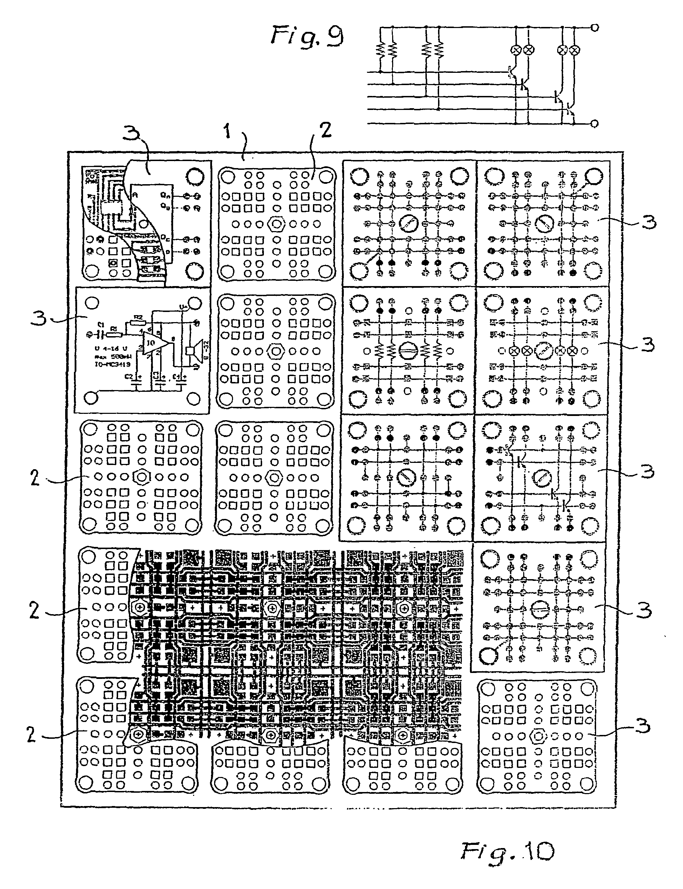

Fig. 7 presents an example of a functional module 3 furnished only with conducting links. This module has the same number and arrangement of contacts 6,7,8,9,10 as described above for one field 4,5 of the primary board 1. Mutual interconnections of individual contacts, incl. nodes, are illustrated by unbroken lines and richly coloured there are all contacts which are to be further interconnected by means of insertion contacts 13. The exemplary functional module 3 is one of modules to be applied for a construction of a circuit according to a diagram illustrated on Fig. 9. The complete practical construction of the respective circuitry by means of the modules according to the invention is shown on Fig. 10.

Fig. 8 illustrates arrangement of a functional module 3 carrying electronic components, namely four transistors 20. The illustrated functional module 3 is again a part of a circuitry the electronic diagram of which is shown on Fig. 9 and the practical embodiment of which is presented on Fig. 10. The Fig. 8 shows all fixed connections and richly coloured all applied connecting contacts 14. By means of insertion contacts 13 applied in corresponding bushings 12 of the connection module 2, all four transistors 20 shall be interconnected as shown on the electric diagram of Fig. 9. For another diagram there may be used only some of the transistors 20 of the given functional module 2, or even only a single one of discussed transistors 20.

As shown on Fig. 10, the inner arrangement of the functional module 3 may be preferably illustrated directly on the cover top 21 of the module housing 16, as shown in the left upper corner of Fig. 10. The illustration on the cover top 21 shows also the connecting contacts 14 which are to be furnished with the insert contacts 13 for connection of components comprised within the module. For marking of the contacts and their mutual interconnections and for their easier differentiation and better orientation of a person applying a module, various colours and shapes for each contact point may be used.

For connection of at least one power source there are used the supply contacts 10. Nevertheless there may be used other means, like a special functional module 3 furnished with appropriate power means.

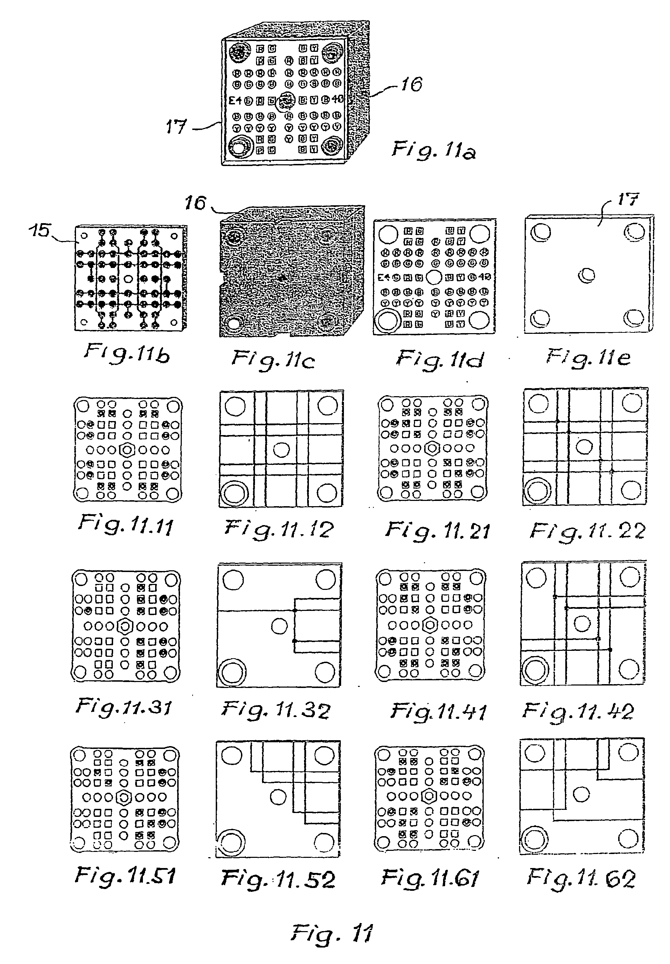

The versatility of the hereby presented kit is demonstrated by Fig. 11 showing the functional module 3 and its parts. From many available applications there are shown six configurations of the same module. The illustrated functional module 3 is the very same one as presented on Fig. 7. On Fig. 11A there is an axonometric view upon a complete module. To pick-out and differentiate mutually interconnected contacts 6,7,8,9 there are used letters R, B, G, Y, representing red, blue, green and yellow colours. Fig. 11B shows a bottom view on the module base 15 with marked fixed connections between the contacts 6,7,8,9. On Fig. 11C there is shown the housing 16, manufactured as a die-cast item of a plastic material. Fig. 11D shows a sheet with contact depiction. The sheet is inserted between the housing 16 and the transparent cover 17, which is separately shown on Fig. 11E. The other Figs. numbered from 11.11 to 11.62 present the six various interconnections of the functional module 3 according to Fig. 11B. By insertion of insertion contacts 13 into appropriate bushings 12 of the connection module 2, as is richly marked for the first variant on Fig. 11.11, the said module is in a configuration according to a diagram of Fig. 11.12. Similarly for the second variant the distribution of the applied insertion contacts 13 is shown on Fig. 11.21, while the corresponding wiring is presented on Fig. 11.22. The third variant is presented on a similar pair of Fig. 11.31 and Fig. 11.32, the fourth variant on a pair of Figs 11.41 and Fig. 11.42, the fifth variant a pair of Figs 11.51 and Fig. 11.52 and the sixth variant a pair of Figs 11.61 and Fig. 11.62

The above discussed kit allows for application of ready-made functional modules 3 as well as the modules prepared by the user himself.

### Industrial applications

The kit according to present invention is designed for didactic purposes and for laic designs of apparatus and equipment. The kit may be used also for design of control and monitoring panels of sophisticated structures.

## Claims

1. Electro-technical kit comprising a primary board, connection means and modules with electromechanical elements, **characterised in, that** the primary board (1) is on its both faces divided into an array of first fields (4) and second fields (5), each of the first fields (4) at one board face being assigned to a second field (5) at the other board face and each field (4,5) being provided with a system of solid, regularly arranged outside contacts (6), inside contacts (7) and axis contacts (8,9), of which the outside contacts (6) are connected with outside contacts (6) of adjacent fields (4,5), inside contacts (7) of the first fields (4) are by means of horizontal links connected with inside contacts (7) of the same field and with at least some outside contacts (6) of an adjacent field, inside contacts (7) of the second fields (5) are by means of horizontal links connected with inside contacts (7) of the same field and with at least some outside contacts (6) of an adjacent field, vertically arranged axis central contacts (8) of the first and second fields (4,5) are by means of horizontal links connected with vertically arranged axis central contacts (8) of adjacent fields (4,5), horizontally arranged axis central contacts (8) of the first and second fields (4,5) are by means of vertical links connected with horizontally arranged axis central contacts (8) of adjacent fields (4,5) and axis peripheral contacts (9) of both fields (4,5) are connected with identically located axis peripheral contacts (9) of at least some of the first and second fields (4,5), while on at least one of the fields (4,5) of the primary board (1) there is placed a separate connection module (2) provided with a system of bushings (12) for insertion of insertion contacts (13), the arrangement of bushings (12) corresponding to the arrangement of solid contacts of each field (4,5) and the connection module (2) is adapted to hold a functional module (3) the connecting contacts (14) of which are arranged at places the positions of which correspond to positions of at least some of the bushings (12) of the connection module (2).

2. Electro-technical kit according to claim 1, **characterised in, that** the primary board (1) comprise means for connection of at least one supply source.

3. Electro-technical kit according to claim 1 or 2, **characterised in, that** each field (4,5) comprise means for attachment of the connection module (2) and the functional module (3).

4. Electro-technical kit according to any of preceding claims, **characterised in, that** a insertion contact (13) is provided for by a coil spring.

5. Electro-technical kit according to any of preceding claims, **characterised in, that** the functional module (3) comprise a housing (16) in which there is placed at least one base (15) carrying at least one electronic element and/or at least one conductor, the terminals of which are led to the bottom face of the base (15), the housing being provided with a mounting element for attachment of the module (3) to the primary board (1).

6. Electro-technical kit according to any of preceding claims, **characterised in, that** outside contacts (6) and/or axis central contacts (8) of each first field (4) on a facial side of the primary board (1) are connected with outside contacts (6) and/or axis central contacts (8) of a respective specularly located second field (5) of the primary board reverse side and outside contacts (6) and/or axis central contacts (8) of each second field (5) on a facial side of the primary board (1) are connected with outside contacts (6) and/or axis central contacts (8) of a respective specularly located second field (5) of the primary board reverse side, such connection being provided for on at least part of the primary board (1).

7. Electro-technical kit according to any of preceding claims, **characterised in, that** at least one field (4,5) of the primary board is provided with at least one pair of supply contacts.

8. Electro-technical kit according to any of preceding claims, **characterised in, that** at least some axis peripheral contacts (9) and at least some supply contacts (10) of at least one first field (4) and one second field (5) are connected with at least some of equally located axis peripheral contacts (9) and/or supply contacts (10) of adjacent field (4,5)

## Patentansprüche

1. Elektrotechnisches Kit, bestehend aus einer Grundplatte, aus Verbindungsmitteln, und aus Modulen mit elektrotechnischen Mitteln, **dadurch gekennzeichnet, dass** die Grundplatte (1) entlang beider Seiten in erste Felder (4) und in zweite Felder (5) unterteilt ist, und zwar ist einem jeden auf der einen Seite liegenden, ersten Feld (4) ein auf der entgegen gesetzten Seite befindliches, zweites Feld (5) zugeordnet, und jedes Feld (4,5) ist mit einem System von festen, regelmäßig angeordneten Außenkontakten (6), Innenkontakten (7) und axialen Kontakten (8,9) versehen, zugleich sind die Außenkontakte (6) mit den Außenkontakten (6) der Nachbarfelder (4,5) zusammengeschaltet, in gleicher Weise sind die Innenkontakte (7) der ersten Felder (4) über horizontal geführte Brücken mit den Innenkontakten (7) desselben Feldes und mit wenigstens einigen Außenkontakten (6) des Nachbarfeldes verbunden, ebenso sind die Innenkontakte (7) der zweiten Felder (5) über horizontal geführte Brücken mit den Innenkontakten (7) desselben Feldes und mit wenigstens einigen Außenkontakten (6) des Nachbarfeldes verbunden, auch sind die vertikal angeordneten, inneren, axialen Kontakte (8) der ersten und zweiten Felder (4,5) mit Hilfe horizontal geführter Brücken mit vertikal angeordneten, inneren, axialen Kontakten (8) der Nachbarfelder verbunden, gleichfalls sind die horizontal angeordneten, inneren, axialen Kontakte (8) eines ersten sowie eines zweiten Feldes (4,5) durch vertikal geführte Brücken mit horizontal angeordneten inneren, axialen Kontakten (8) der Nachbarfelder verbunden, genauso sind die äußeren, am Rande liegenden, axialen Kontakte (9) der beiden Felder (4,5) mit gleich positionierten, äußeren, am Rande liegenden, axialen Kontakten (9) von zumindest einigen der ersten und zweiten Felder verbunden, dabei ist zumindest in irgend-einem Feld (4.5) der Grundplatte (1) ein selbständiges Verbindungsmodul (2) eingebaut, das mit einem System von Durchführungen (12) zur Platzierung von Wechselkontakten (13) versehen ist, und zwar so, dass die Anordnung der Durchführungen (12) der Anordnung der festen Kontakte eines jeden Feldes (4,5) entspricht, und dass das Verbindungsmodul (2) in der Lage ist, das Funktionsmodul aufzunehmen (3), dessen Anschlusskontakte (14) an Stellen münden, deren Lage wenigstens der Position einiger Durchführungen (12) des Verbindungsmoduls entspricht (2)

2. Elektrotechnisches Kit nach Anspruch 1, **dadurch gekennzeichnet, dass** die Grundplatte (1) mit Anschlussmitteln für immerhin ein Netzgerät versehen ist.

3. Elektrotechnisches Kit nach Anspruch 1 oder 2, **dadurch gekennzeichnet, dass** jedes Feld (4,5) mit Mitteln zur Befestigung des Verbindungsmoduls (2) sowie des Funktionsmoduls (3) versehen ist.

4. Elektrotechnisches Kit nach irgendeinem der vorherigen Ansprüche, **dadurch gekennzeichnet, dass** der Wechselkontakt (13) in einer Spiralfeder besteht.

5. Elektrotechnisches Kit nach irgendeinem der vorherigen Ansprüche, **dadurch gekennzeichnet, dass** das Funktionsmodul (3) mit einem Deckgehäuse (16) versehen ist, in dem wenigstens eine Platte montiert ist, an der mindestens ein elektronisches Element und/oder ein Leiter befestigt sind/ist, deren Anschlüsse an die untere Fläche der Plattform (15) herangeführt sind, wobei das Gehäuse (16) mit einem Montageelement für die Verbindung dieses Moduls mit der Grundplatte (1) versehen ist.

6. Elektrotechnisches Kit nach irgendeinem der vorherigen Ansprüche, **dadurch gekennzeichnet, dass** die Außenkontakte (6) und/oder die inneren axialen Kontakte (8) eines jeden, auf der Oberseite der Grundplatte (1) liegenden, ersten Feldes (4) mit Außenkontakten (6) und/oder inneren axialen Kontakten (8) eines zu ihnen spiegelbildlich angeordneten, auf der Rückseite der Grundplatte (1) liegenden, zweiten Feldes (5) zusammengeschaltet sind, und dass die Außenkontakte (6) und/oder die inneren axialen Kontakte (8) eines jeden, auf der Oberseite der Grundplatte (1) liegenden, zweiten Feldes (4) mit Außenkontakten (6) und/oder inneren axialen Kontakten (8) eines zu ihnen spiegelbildlich angeordneten, auf der Rückseite der Grundplatte (1) liegenden, ersten Feldes (5) zusammengeschaltet sind, wobei eine solche Vernetzung wenigstens auf einem Teil der Grundplatte (1) gegeben sein muss.

7. Elektrotechnisches Kit nach irgendeinem der vorherigen Ansprüche, **dadurch gekennzeichnet, dass** wenigstens ein Feld (4,5) der Grundplatte (1) mit mindestens einem Paar der Versorgungskontakte (10) versehen ist.

8. Elektrotechnisches Kit nach irgendeinem der vorherigen Ansprüche, **dadurch gekennzeichnet, dass** mindestens einige der äußeren, am Rande liegenden, axialen Kontakte (9) und wenigstens einige der Versorgungskontakte (10) von zumindest irgendeinem der ersten sowie der zweiten Felder (4,5) mit immerhin einigen, gleich positionierten äußeren, am Rande liegenden, axialen Kontakten (9) und/oder Versorgungskontakten (10) des Nachbarfeldes (4,5) verbunden sind.

## Revendications

1. Trousse électrotechnique comportant une plaque de base, des moyens de liaison et des modules aux éléments électrotechniques **caractérisée en ce que** la plaque de base (1) est sur ses deux côtés divisée dans les premier champs (4) et deuxième champs (5), dont chaque premier champ (4) communique sur l'autre côté avec le deuxième champ (5) sur son côté opposé, et chaque champ (4,5) est muni d'un système de contacts extérieurs solides (6) disposés de manière régulière, de contacts intérieurs (7) et de contacts axiaux (8,9) dont les contacts extérieurs (6) sont reliés aux contacts extérieurs (6) des champs voisins (4,5), les contacts intérieurs (7) des premiers champs (4) communiquent par le biais des joints horizontaux avec les contacts intérieurs (7) du même champ et avec au moins quelques contacts extérieurs (6) du champ voisin, les contacts intérieurs (7) des deuxième champs (5) étant reliés par les joints horizontaux avec les contacts intérieurs (7) du même champ et avec au moins quelques contacts extérieurs (6) du champ voisin, disposés verticalement, les contacts axiaux intérieurs (8) des premier et des deuxième champs (4,5) étant reliés à l'aide des joints disposés verticalement par le biais des contacts axiaux intérieurs disposés horizontalement, les contacts axiaux intérieurs (8) des champs voisins et des contacts axiaux intérieurs (8) du premier et du deuxième champ (4,5) étant reliés par les joints horizontaux avec les contacts axiaux intérieurs (8) des champs voisins, et les contacts axiaux périphériques (9) des deux champs (4,5) étant reliés avec les contacts axiaux disposés de la même manière (9) ou au moins quelques premiers et deuxième champs, sur au moins un des champs (4,5) de la plaque de base (1) étant disposé un module de raccordement à part (2) muni d'un système de traversées (12) pour disposer des contacts de rechange (13) où la disposition des traversées (12) correspond à la disposition des contacts fixes de chaque champ (4,5) et le module de liaison (2) étant adapté au logement du module fonctionnel (3) dont les contacts de liaison (14) débouchent dans les points dont les positions correspondent avec la position d'au moins quelques traversées (12) du module de liaison (2).

2. Trousse électrotechnique selon la revendication 1, **caractérisée en ce que** la plaque de base (1) est munie des moyens pour la connexion d'au moins une source d'alimentation.

3. Trousse électrotechnique selon la revendication 1 ou 2 **caractérisée en ce que** chaque champ (4,5) est muni des moyens pour la fixation du module de liaison (2) et du module fonctionnel (3).

4. Trousse électrotechnique selon l'une des revendications précédentes **caractérisée en ce que** le contact de rechange (13) est constitué du ressort enroulé.

5. Trousse électrotechnique selon l'une des revendications précédentes **caractérisée en ce que** le module fonctionnel (3) est muni d'une douille (16) comportant au moins une plaque sur laquelle est fixé au moins un élément électronique et/ou au moins un conducteur dont les sorties débouchent sur la surface inférieure de la base (15), la douille (16) étant munie d'un élément de montage servant au raccordement de ce module avec la plaque de base (1).

6. Trousse électrotechnique selon l'une des revendications précédentes **caractérisée en ce que** les contacts extérieurs (6) et/ou les contacts intérieurs axiaux (8) de chaque premier champ (4) sur la face de la plaque de base (1) sont reliées avec les contacts extérieurs (6) et/ou contacts axiaux intérieurs (8) du deuxième champ (5), situés sur le revers de la plaque de base (1) et les contacts extérieurs (6) et/ou les contacts axiaux intérieurs (8) de chaque deuxième champ (4) sur la face de la plaque de base (1) étant reliés avec les contacts extérieurs (6) et/ou contacts axiaux intérieurs (8) du premier champ opposé (5) du revers de la plaque de base (1), au moins sur une partie de la plaque de base (1).

7. Trousse électrotechnique selon l'une quelconque revendication **caractérisée en ce que** au moins un champ (4,5) de la plaque de base (1) est muni d'au moins une paire de contacts d'alimentation (10).

8. Trousse électrotechnique selon l'une quelconque des revendications **caractérisée en ce que** au moins quelques contacts axiaux périphériques (9) et au moins quelques contacts d'alimentation (10) d'au moins premier et deuxième champ (4,5) sont reliés avec quelques contacts axiaux périphériques (9) et/ou les contacts d'alimentation (10) du champ voisin 4,5.
